# EUROPEAN PATENT APPLICATION

(11) **EP 2 810 785 A1**
(43) Date of publication of application: **10.12.2014**
(21) Application number: 13744032.7
(22) Date of filing: 25.01.2013
(51) Int. Cl.: B41N 1/12, C08F 2/44, C08F 283/00, G03F 7/00, G03F 7/035

(54) **RESIN COMPOSITION FOR LASER ENGRAVING, LASER ENGRAVING-TYPE FLEXOGRAPHIC PRINTING PLATE MOLD AND PRODUCTION METHOD THEREFOR, AND FLEXOGRAPHIC PRINTING PLATE AND PLATE-MAKING METHOD THEREFOR**

(30) Priority: 30.01.2012 JP 2012017079
(71) Applicant: Fujifilm Corporation, Minato-ku Tokyo 106-8620 (JP)
(72) Inventor: KOZAWA Yuusuke, Haibara-gun Shizuoka 421-0396 (JP)
(74) Representative: Hoffmann Eitle
(86) International application number: PCT/JP2013/051545
(87) International publication number: WO 2013/115081

(57) **Abstract**

To provide a resin composition for laser engraving that can give a flexographic printing plate precursor for laser engraving that is excellent in terms of engraving residue rinsing properties and scattering inhibition, a flexographic printing plate precursor for laser engraving and a process for producing same employing the resin composition for laser engraving, and a flexographic printing plate and a process for making same.

A resin composition for laser engraving, comprising(Component A) a polyurethane resin comprising a carboxy group-containing polymeric polyol compound-derived constituent unit and an isocyanate compound-derived constituent unit,(Component B) an ethylenically unsaturated compound, and (Component C) a polymerization initiator.

## Description

The present invention relates to a resin composition for laser engraving, a flexographic printing plate precursor for laser engraving and a process for producing the same, and a flexographic printing plate and a process for making the same.

A large number of so-called "direct engraving CTP methods", in which a relief-forming layer is directly engraved by means of a laser are proposed. In the method, a laser light is directly irradiated to a flexographic printing plate precursor to cause thermal decomposition and volatilization by photothermal conversion, thereby forming a concave part. Differing from a relief formation using an original image film, the direct engraving CTP method can control freely relief shapes. Consequently, when such image as an outline character is to be formed, it is also possible to engrave that region deeper than other regions, or, in the case of a fine halftone dot image, it is possible, taking into consideration resistance to printing pressure, to engrave while adding a shoulder. With regard to the laser for use in the method, a high-power carbon dioxide laser is generally used. In the case of the carbon dioxide laser, all organic compounds can absorb the irradiation energy and convert it into heat. On the other hand, inexpensive and small-sized semiconductor lasers have been developed, wherein, since they emit visible lights and near infrared lights, it is necessary to absorb a laser light and convert it into heat.

As a resin composition for laser engraving, those described in Patent Documents 1 to 3 are known.
Patent Document 1: JP-B-3801592 (JP-B denotes a Japanese examined patent application publication)
Patent Document 2: JP-A-2011-68030 (JP-A denotes a Japanese unexamined patent application publication)
Patent Document 3: JP-A-2008-266553

It is an object of the present invention to provide a resin composition for laser engraving that can give a flexographic printing plate precursor for laser engraving that is excellent in terms of engraving residue rinsing properties and scattering inhibition, a flexographic printing plate precursor for laser engraving and a process for producing same employing the resin composition for laser engraving, and a flexographic printing plate and a process for making same.

The objects of the present invention have been attained by solution means <1> and <8> to <12> below, which are described below together with <2> to <7> as preferred embodiments.
<1> A resin composition for laser engraving, comprising (Component A) a polyurethane resin comprising a carboxy group-containing polymeric polyol compound-derived constituent unit and an isocyanate compound-derived constituent unit, (Component B) an ethylenically unsaturated compound, and (Component C) a polymerization initiator,
<2> the resin composition for laser engraving according to <1> above, wherein Component A has an acid value of 1 to 200 mg KOH/g,
<3> the resin composition for laser engraving according to <1> or <2> above, wherein Component C is a thermopolymerization initiator,
<4> the resin composition for laser engraving according to any one of <1> to <3> above, wherein it further comprises (Component D) a photothermal conversion agent,
<5> the resin composition for laser engraving according to <4> above, wherein Component D is carbon black,
<6> the resin composition for laser engraving according to any one of <1> to <5> above, wherein it further comprises (Component E) a compound comprising at least one type from a hydrolyzable silyl group and a silanol group,
<7> the resin composition for laser engraving according to <6> above, wherein Component E is a compound comprising at least an alkoxy group on a silicon atom,
<8> a flexographic printing plate precursor for laser engraving comprising above a support a relief-forming layer comprising the resin composition for laser engraving according to any one of <1> to <7> above,
<9> a flexographic printing plate precursor for laser engraving comprising above a support a crosslinked relief-forming layer formed by crosslinking by means of light and/or heat a relief-forming layer comprising the resin composition for laser engraving according to any one of <1> to <7> above,
<10> a process for producing a flexographic printing plate precursor for laser engraving, comprising a layer formation step of forming a relief-forming layer comprising the resin composition for laser engraving according to any one of <1> to <7> above, and a crosslinking step of crosslinking the relief-forming layer by means of light and/or heat to thus obtain a flexographic printing plate precursor comprising the crosslinked relief-forming layer,
<11> a process for making a flexographic printing plate, comprising an engraving step of laser-engraving the flexographic printing plate precursor for laser engraving according to <9> above to thus form a relief layer, and
<12> a flexographic printing plate made by the process according to <11> above.

In accordance with the present invention, there can be provided a resin composition for laser engraving that can give a flexographic printing plate precursor for laser engraving that is excellent in terms of engraving residue rinsing properties and scattering inhibition, a flexographic printing plate precursor for laser engraving and a process for producing same employing the resin composition for laser engraving, and a flexographic printing plate and a process for making same.

The present invention is explained in detail below.

In the present invention, the notation 'lower limit to upper limit' expressing a numerical range means 'at least the lower limit but no greater than the upper limit', and the notation 'upper limit to lower limit' means 'no greater than the upper limit but at least the lower limit'. That is, they are numerical ranges that include the upper limit and the lower limit. Further, "(Component A) a polyurethane resin comprising a carboxy group-containing polymeric polyol compound-derived constituent unit and an isocyanate compound-derived constituent unit" etc. are simply called as "Component A" etc.

In the present invention, 'mass%' is the same meaning as 'weight%', and 'parts by mass' is the same meaning as 'parts by weight'.

In the present invention, '(meth)acrylate' means each one or both of 'acrylate' and 'methacrylate'.

### (Resin composition for laser engraving)

The resin composition for laser engraving (hereinafter, also simply called a 'resin composition') of the present invention comprises (Component A) a polyurethane resin comprising a carboxy group-containing polymeric polyol compound-derived constituent unit and an isocyanate compound-derived constituent unit, (Component B) an ethylenically unsaturated compound, and (Component C) a polymerization initiator.

As a result of an intensive investigation by the present inventors, it has been found that, when laser-engraving a flexographic printing plate precursor for laser engraving comprising Component A to Component C, a highly viscous engraving residue is produced; it is difficult to wash and remove this highly viscous engraving residue, and there is also the problem that this engraving residue scatters during an engraving step and stains an engraving machine.

Although the mechanism of action in the present invention is not clear, it is surmised to be as follows.

It has been found that, with regard to a resin composition for laser engraving comprising a polyurethane resin comprising a carboxy group-containing polymeric polyol compound-derived constituent unit and an isocyanate compound-derived constituent unit, an ethylenically unsaturated compound, and a polymerization initiator, a flexographic printing plate precursor for laser engraving that is excellent in terms of engraving residue rinsing properties and scattering inhibition can be provided. It is surmised that improvement of rinsing properties is due to the carboxy group of the polyurethane resin present in the engraving residue taking in water to thus increase solubility in water. Furthermore, with regard to improvement of residue scattering inhibition, it is surmised that the engraving residue is solidified due to hydrogen bonding between the carboxy groups of the polyurethane resin to thus decrease the amount of liquid residue, but the cause thereof is not clear.

As described above, due to the resin composition for laser engraving of the present invention comprising Component A to Component C, a flexographic printing plate precursor for laser engraving that is excellent in terms of engraving residue rinsing properties and scattering inhibition can be obtained.

The resin composition for laser engraving of the present invention may be applied to a wide range of uses where it is subjected to laser engraving, other than use as a relief-forming layer of a flexographic printing plate precursor, without particular limitations. For example, it may be applied not only to a relief-forming layer of a printing plate precursor where formation of a raised relief is carried out by laser engraving, which is explained in detail below, but also to the formation of various types of printing plates or various types of moldings in which image formation is carried out by laser engraving, such as another material form having asperities or openings formed on the surface such as for example an intaglio printing plate, a stencil printing plate, or a stamp.

Among them, the application thereof to the formation of a relief-forming layer provided on an appropriate support is a preferred embodiment.

In the present specification, with respect to explanation of the flexographic printing plate precursor, a non-crosslinked crosslinkable layer comprising Component A to Component C and having a flat surface as an image formation layer that is subjected to laser engraving is called a relief-forming layer, a layer that is formed by crosslinking the relief-forming layer is called a crosslinked relief-forming layer, and a layer that is formed by subjecting this to laser engraving so as to form asperities on the surface is called a relief layer.

Constituent components of the resin composition for laser engraving are explained below.

### (Component A) Polyurethane resin comprising carboxy group-containing polymeric polyol compound-derived constituent unit and isocyanate compound-derived constituent unit

The resin composition for laser engraving of the present invention comprises (Component A) a polyurethane resin comprising a carboxy group-containing polymeric polyol compound-derived constituent unit and an isocyanate compound-derived constituent unit.

Component A may comprise one type of carboxy group-containing polymeric polyol compound-derived constituent unit on its own or two or more types thereof.

Furthermore, Component A may comprise one type of isocyanate compound-derived constituent unit on its own or two or more types thereof.

Component A may further comprise a constituent unit other than the carboxy group-containing polymeric polyol compound-derived constituent unit or the isocyanate compound-derived constituent unit.

A method for analyzing the structure of Component A is not particularly limited, and a known method may be used.

The weight-average molecular weight Mw of Component A is preferably 5,000 to 1,000,000, more preferably 10,000 to 750,000, yet more preferably 50,000 to 500,000, particularly preferably 150,000 to 400,000, and most preferably 200,000 to 300,000. As a method for measuring weight-average molecular weight Mw or number-average molecular weight Mn of a resin, etc. in the present invention, a method in which measurement is carried out using a GPC (gel permeation chromatography) method and determination is carried out using a polystyrene standard calibration curve can be cited as a preferred example.

The acid value of Component A is preferably 1 to 200 mg KOH/g, more preferably 2 to 100 mg KOH/g, yet more preferably 5 to 50 mg KOH/g, and particularly preferably 10 to 50 mg KOH/g. When in the above range, a flexographic printing plate precursor for laser engraving that is excellent in terms of engraving residue rinsing properties and scattering inhibition can be obtained.

A method for measuring acid value in the present invention is not particularly limited and may be selected as appropriate from known methods; examples thereof include a titration method, and a method in which acid value is measured by titration using potassium hydroxide can be cited as a preferred example.

### <Carboxy group-containing polymeric polyol compound-derived constituent unit>

Component A comprises a carboxy group-containing polymeric polyol compound-derived constituent unit.

The weight-average molecular weight Mw of the carboxy group-containing polymeric polyol compound is preferably 1,000 to 100,000, more preferably 3,000 to 80,000, and yet more preferably 5,000 to 60,000. When in the above range, a flexographic printing plate precursor for laser engraving that is excellent in terms of engraving residue rinsing properties and scattering inhibition can be obtained.

The acid value of the carboxy group-containing polymeric polyol compound is preferably 1 to 200 mg KOH/g, more preferably 2 to 100 mg KOH/g, yet more preferably 5 to 50 mg KOH/g, and particularly preferably 10 to 50 mg KOH/g. When in the above range, a flexographic printing plate precursor for laser engraving that is excellent in terms of engraving residue rinsing properties and scattering inhibition can be obtained.

The carboxy group-containing polymeric polyol compound is not particularly limited as long as it is a polymer compound comprising at least one carboxy group and at least two hydroxy groups; examples of the polymer compound include an acrylic resin, polyester resin, polyurethane resin, polyester urethane resin, polyamide resin, polysulfone resin, polyether sulfone resin, polyimide resin, hydroxyethylene unit-containing hydrophilic polymer, polystyrene resin, acetal resin, or polycarbonate resin comprising at least one carboxy group and at least two hydroxy groups.

Among them, an acrylic resin, polyester resin, or polyester urethane resin comprising at least one carboxy group and at least two hydroxy groups is preferable, an acrylic resin or polyester resin comprising at least one carboxy group and at least two hydroxy groups is more preferable, and a polyester resin comprising at least one carboxy group and at least two hydroxy groups is yet more preferable.

Preferred examples of the acrylic resin comprising at least one carboxy group and at least two hydroxy groups include an acrylic resin comprising an unsaturated carboxylic acid compound-derived constituent unit and a hydroxy group-containing (meth)acrylic monomer-derived constituent unit.

Examples of the unsaturated carboxylic acid compound include acrylic acid, methacrylic acid, itaconic acid, crotonic acid, isocrotonic acid, and maleic acid.

Examples of the acrylic monomers comprising a hydroxy group used for synthesizing an acrylic resin having at least two hydroxy groups include preferably (meth)acrylic acid esters, crotonic acid esters and (meth)acrylamides having a hydroxy group in the molecule. Specific examples of such monomers include 2-hydroxyethyl (meth)acrylate, 2-hydroxypropyl (meth)acrylate, 4-hydroxybutyl (meth)acrylate etc.

Examples of acrylic monomers other than those described above preferably include a (meth)acrylic ester.

Examples of the (meth)acrylic ester, methyl (meth)acrylate, ethyl (meth)acrylate, *n*-propyl (meth)acrylate, isopropyl (meth)acrylate, *n*-butyl (meth)acrylate, isobutyl (meth)acrylate, *t*-butyl (meth)acrylate, *n*-hexyl (meth)acrylate, 2-ethylhexyl (meth)acrylate, acetoxyethyl (meth)acrylate, phenyl (meth)acrylate, 2-methoxyethyl (meth)acrylate, 2-ethoxyethyl (meth)acrylate, 2-(2-methoxyethoxy)ethyl (meth)acrylate, cyclohexyl (meth)acrylate, *t*-butyl cyclohexyl (meth)acrylate, benzyl (meth)acrylate, lauryl(meth)acrylate, diethylene glycol monomethyl ether (meth)acrylate, diethylene glycol monoethyl ether (meth)acrylate, diethylene glycol monophenyl ether (meth)acrylate, triethylene glycol monomethyl ether (meth)acrylate, triethylene glycol monoethyl ether (meth)acrylate, dipropylene glycol monomethyl ether (meth)acrylate, polyethylene glycol monomethyl ether (meth)acrylate, polypropylene glycol monomethyl ether (meth)acrylate, the monomethyl ether (meth)acrylate of a copolymer of ethylene glycol and propylene glycol, *N,N*-dimethylaminoethyl (meth)acrylate, *N,N-*diethylaminoethyl (meth)acrylate, and *N,N*-dimethylaminopropyl (meth)acrylate.

When preparing an acrylic resin comprising a carboxy group and at least two hydroxy groups, one type of each of an unsaturated carboxylic acid compound, an acrylic monomer comprising a hydroxy group, and another acrylic monomer may be used on its own, or two or more types may be used in combination.

The polyester resin comprising a carboxy group and at least two hydroxy groups may be formed by an esterification reaction or an ester exchange reaction between at least one type of polybasic acid component and at least one type of polyhydric alcohol component.

The polybasic acid component and the polyhydric alcohol component are not particularly limited, and known compounds that can be used for production of a polyester resin may be used.

Specific examples of the polybasic acid component include dibasic acids such as phthalic acid, isophthalic acid, terephthalic acid, tetrahydrophthalic acid, hexahydrophthalic acid, succinic acid, fumaric acid, adipic acid, sebacic acid, and maleic acid; trivlaent or higher-valent polybasic acids such as trimellitic acid, methylcyclohexene tricarboxylic acid, and pyromellitic acid; and acid anhydrides thereof, for example, phthalic anhydride, tetrahydrophthalic anhydride, hexahydrophthalic anhydride, maleic anhydride, trimellitic anhydride, and pyromellitic anhydride.

As the polybasic acid component, one or more dibasic acids selected from the dibasic acids described above, lower alkyl ester compounds of these acids, and acid anhydrides are mainly used. Furthermore, if necessary, a monobasic acid such as benzoic acid, crotonic acid or *p*-t-butylbenzoic acid; a trivalent or higher-valent polybasic acid such as trimellitic anhydride, methylcyclohexene tricarboxylic acid or pyromellitic anhydride; or the like can be further used in combination. With regard to these polybasic acid components, one type maybe used on its own or two or more types may be used in combination.

Specific examples of the polyhydric alcohol component include divalent alcohols such as ethylene glycol, diethylene glycol, propylene glycol, dipropylene glycol, 1,4-butanediol, neopentyl glycol, 1,5-pentanediol, 3-methylpentanediol, 1,4-hexanediol, and 1,6-hexanediol; and trivalent or higher-valent polyhydric alcohols such as glycerin, trimethylolethane, trimethylolpropane, and pentaerythritol.

As the polyhydric alcohol component, the divalent alcohols described above are mainly used, and if necessary, trivalent or higher-valent polyhydric alcohols such as glycerin, trimethylolethane, trimethylolpropane, and pentaerythritol can be further used in combination. These polyhydric alcohols can be used individually, or as mixtures of two or more kinds.

The polyhydric alcohol component according to the present invention preferably includes at least 3-methylpentanediol, from the viewpoint of storage stability.

The esterification reaction or transesterification reaction of the polybasic acid component and the polyhydric alcohol component can be carried out by using a usually used method without particular limitations.

A method for introducing a carboxy group or a hydroxy group into a polyester resin is not particularly limited; for example, synthesis may be carried out so that a resin terminal is a carboxy group or a hydroxy group, or when introducing a carboxy group or a hydroxy group into the interior of a resin chain, there can be cited a method in which a compound comprising a hydroxy group and carboxy group and having a total of three or more of these groups, such as a dihydroxycarboxylic acid compound or a monohydroxydicarboxylic acid compound, is used as one component among the polybasic acid component and the polyhydric alcohol component.

There is also a method in which a polyester polyol is synthesized by a known method and some of the hydroxy groups of the polyester polyol are reacted with an acid anhydride to thus introduce a carboxy group. Examples of the acid anhydride include phthalic anhydride, tetrahydrophthalic anhydride, hexahydrophthalic anhydride, maleic anhydride, trimellitic anhydride, and pyromellitic anhydride.

Furthermore, there can be cited a method in which a lactone is subjected to ring-opening addition-polymerization with a polyhydroxycarboxylic acid compound.

### <Isocyanate compound-derived constituent unit>

Component A comprises a isocyanate compound-derived constituent unit.

Preferred examples of the isocyanate compound include tolylene diisocyanate, diphenylmethane diisocyanate, hexamethylene diisocyanate, isophorone diisocyanate, dicyclohexylmethane diisocyanate, tetramethylxylene diisocyanate, xylene diisocyanate, naphthalene diisocyanate, trimethylhexamethylene diisocyanate, p-phenylene diisocyanate, cyclohexylene diisocyanate, lysine diisocyanate, triphenylmethane diisocyanate, or a triisocyanate compound such as triphenylmethane triisocyanate, 1-methylbenzene-2,4,6-triisocyanate, naphthaline-1,3,7-triisocyanate, or biphenyl-2,4,4'-triisocyanate.

Furthermore, the isocyanate compound is preferably a diisocyanate compound, more preferably an aliphatic diisocyanate compound, yet more preferably an alkylene diisocyanate having 2 to 10 carbons, and particularly preferably hexamethylene diisocyanate. When in the above mode, a flexographic printing plate precursor for laser engraving that is excellent in terms of engraving residue rinsing properties and scattering inhibition can be obtained.

The isocyanate compound-derived constituent unit is preferably a diisocyanate compound-derived constituent unit, more preferably an aliphatic diisocyanate compound-derived constituent unit, and particularly preferably a constituent unit represented by Formula (a2) below. When in the above mode, a flexographic printing plate precursor for laser engraving that is excellent in terms of engraving residue rinsing properties and scattering inhibition can be obtained. 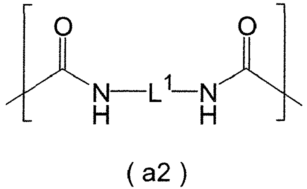 (In Formula (a2), L¹ denotes an alkylene group having 2 to 8 carbons.)

The alkylene group denoted by L¹ may be a straight chain or be branched or may have a ring structure, such as in cyclohexylene diisocyanate, but is preferably a straight chain alkylene group. The number of carbons of the alkylene group denoted by L¹ is preferably 4 to 8, and more preferably 5 to 7.

### <Other constituent unit>

Component A may comprise a constituent unit other than the carboxy group-containing polymeric polyol compound-derived constituent unit and the isocyanate compound-derived constituent unit.

Examples of the other constituent unit include a polyol compound-derived constituent unit other than the carboxy group-containing polymeric polyol compound.

Furthermore, the other constituent unit may comprise a carboxy group or a hydroxy group.

As the polyol compound, a known polyol compound or a chain extension agent used in the production of a polyurethane resin may be used without particular limitation.

Specific examples of the polyol compound include divalent alcohols such as ethylene glycol, diethylene glycol, propylene glycol, dipropylene glycol, 1,4-butanediol, neopentyl glycol, 1,5-pentanediol, 3-methylpentanediol, 1,4-hexanediol, and 1,6-hexanediol; and trivalent or higher-valent polyhydric alcohols such as glycerol, trimethylolethane, trimethylolpropane, and pentaerythritol.

With regard to Component A in the resin composition of the present invention, one type thereof may be used on its own or two or more types may be used in combination.

The content of Component A in the resin composition is preferably 5 to 90 mass% relative to the entire solids content, more preferably 15 to 85 mass%, and yet more preferably 30 to 80 mass%. It is preferable for the content of Component A to be in the above range since a flexible relief layer having excellent engraving residue rinsing properties can be obtained. The solids content of the composition referred to here is the amount excluding solvent in the composition.

The resin composition for a flexographic printing plate of the present invention may comprise a resin other than Component A. The examples of the resin other than Component A include the non-elastomers described in JP-A-2011-136455, and the unsaturated group-containing polymers described in JP-A-2010-208326.

The resin composition for a flexographic printing plate of the present invention preferably comprises Component A as a main component of the binder polymers (resin component), and if the resin composition comprises other resin, the content of Component A relative to the total weight of the binder polymers is preferably 60 mass% or greater, more preferably 70 mass% or greater, and yet more preferably 80 mass% or greater. Meanwhile, the upper limit of the content of Component A relative to the total weight of the binder polymers is not particularly limited, but if the resin composition comprises other resin, the upper limit thereof is preferably 99 mass% or less, more preferably 97 mass% or less, and yet more preferably 95 mass% or less. (Component B) Ethylenically unsaturated compound

The resin composition for laser engraving of the present invention comprises (Component B) an ethylenically unsaturated compound. The ethylenically unsaturated compound is a compound comprising at least one ethylenically unsaturated bond that can undergo radical polymerization by means of an initiating radical derived and generated from a polymerization initiator. Due to it comprising an ethylenically unsaturated compound it is possible to impart to the relief-forming layer the property of curing by crosslinking.

The ethylenically unsaturated compound may be selected freely from compounds having at least one, preferably at least two, and more preferably 2 to 6 ethylenically unsaturated bonds. The molecular weight (weight-average molecular weight) of the ethylenically unsaturated compound is less than 2,000. Component B does not include a compound comprising a hydrolyzable silyl group and/or a silanol group. With regard to the ethylenically unsaturated compound, a known compound may be used without particular limitation, and examples thereof include polymerizable compounds (hereinafter, also called monomers) described in JP-A-2009-255510 and paragraphs 0098 to 0124 of JP-A-2009-204962.

Since it is necessary to form a crosslinked structure in the relief-forming layer in the present invention, a polyfunctional monomer having at least two ethylenically unsaturated bond is preferably used as Component B. The molecular weight of these polyfunctional monomers is preferably at least 120 and less than 2,000, and more preferably at least 200 and less than 2,000.

Examples of the monofunctional monomer and polyfunctional monomer include an ester of an unsaturated carboxylic acid (e.g. acrylic acid, methacrylic acid, itaconic acid, crotonic acid, isocrotonic acid, maleic acid, etc.) and a polyhydric alcohol compound and an amide of an unsaturated carboxylic acid and a polyamine compound.

Specific examples of a monomer that is an ester of an aliphatic polyhydric alcohol compound and an unsaturated carboxylic acid include a (meth)acrylic acid ester such as ethylene glycol di(meth)acrylate, triethylene glycol di(meth)acrylate, 1,3-butanediol di(meth)acrylate, tetramethylene glycol di(meth)acrylate, propylene glycol di(meth)acrylate, neopentyl glycol di(meth)acrylate, trimethylolpropane tri(meth)acrylate, trimethylolpropane tri((meth)acryloyloxypropyl) ether, ditrimethylol propane tetra(meth)acrylate, trimethylolethane tri(meth)acrylate, hexanediol di(meth)acrylate, 1,4-cyclohexanediol di(meth)acrylate, tetraethylene glycol di(meth)acrylate, pentaerythritol di(meth)acrylate, pentaerythritol tri(meth)acrylate, pentaerythritol tetra(meth)acrylate, dipentaerythritol di(meth)acrylate, dipentaerythritol hexa(meth)acrylate, sorbitol tri(meth)acrylate, sorbitol tetra(meth)acrylate, sorbitol penta(meth)acrylate, sorbitol hexa(meth)acrylate, tri((meth)acryloyloxyethyl) isocyanurate, bis[p-(3-(meth)acryloxy-2-hydroxypropoxy)phenyl]dimethylmethane, bis[*p-*((meth)acryloxyethoxy)phenyl]dimethylmethane, tricyclodecane dimethanol di(meth)acrylate, hydrogenated bisphenol A di(meth)acrylate, hydrogenated bisphenol F di(meth)acrylate, a di(meth)acrylate of an ethylene oxide adduct of bisphenol A, a di(meth)acrylate of a propylene oxide adduct of bisphenol A, a di(meth)acrylate of an ethylene oxide adduct of bisphenol F, a di(meth)acrylate of a propylene oxide adduct of bisphenol F, a di(meth)acrylate of an ethylene oxide adduct of hydrogenated bisphenol A, and a di(meth)acrylate of a propylene oxide adduct of hydrogenated bisphenol A, and among them a di- to hexa-functional (meth)acrylate derivative of pentaerythritol or dipentaerythritol and a bisphenol type di(meth)acrylate are preferable, and dipentaerythritol hexa(meth)acrylate and bisphenol A-based di(meth)acrylate are more preferable. As the bisphenol A-based di(meth)acrylate, one having added thereto one to six ethylene oxide groups per molecule is yet more preferable. The ester monomer may be used as a mixture.

Among them, at least one type of ethylenically unsaturated compound selected from the group consisting of tricyclodecanedimethanol di(meth)acrylate, ditrimethylolpropane tetra(meth)acrylate, and dipentaerythritol hexa(meth)acrylate is particularly preferable.

In the present invention, Component B may be used singly or in a combination of two or more types.

From the viewpoint of flexibility and brittleness of the crosslinked film, the content of Component B in the resin composition of the present invention is preferably 0.01 to 80 mass% relative to the total mass on a solid component basis, more preferably 1 to 60 mass%, and yet more preferably 3 to 30 mass%.

### (Component C) polymerization initiator

The resin composition for laser engraving of the present invention comprises (Component C) a polymerization initiator.

With regard to the polymerization initiator, one known to a person skilled in the art may be used without any limitations. Radical polymerization initiators, which are preferred polymerization initiators, are explained in detail below, but the present invention should not be construed as being limited to these descriptions.

### (Component C) the polymerization initiator is preferably a radical polymerization initiator.

The polymerization initiator may be a photopolymerization initiator or a thermopolymerization initiator, and is preferably a thermopolymerization initiator.

In the present invention, preferable polymerization initiators include (a) aromatic ketones, (b) onium salt compounds, (c) organic peroxides, (d) thio compounds, (e) hexaallylbiimidazole compounds, (f) ketoxime ester compounds, (g) borate compounds, (h) azinium compounds, (i) metallocene compounds, (j) active ester compounds, (k) compounds having a carbon halogen bond, and (I) azo compounds. Hereinafter, although specific examples of the (a) to (I) are cited, the present invention is not limited to these.

In the present invention, when applies to the relief-forming layer of the flexographic printing plate precursor, from the viewpoint of engraving sensitivity and making a favorable relief edge shape, (c) organic peroxides and (I) azo compounds are more preferable, and (c) organic peroxides are particularly preferable.

The (a) aromatic ketones, (b) onium salt compounds, (d) thio compounds, (e) hexaallylbiimidazole compounds, (f) ketoxime ester compounds, (g) borate compounds, (h) azinium compounds, (i) metallocene compounds, (j) active ester compounds, and (k) compounds having a carbon halogen bonding may preferably include compounds described in paragraphs 0074 to 0118 of JP-A-2008-63554.

Moreover, (c) organic peroxides and (I) azo compounds preferably include the following compounds.

### (c) Organic peroxide

Preferred examples of the organic peroxide (c) as a polymerization initiator include peroxyester-based ones such as 3,3',4,4'-tetra(*t-*butylperoxycarbonyl)benzophenone, 3,3',4,4'-tetra(*t-*amylperoxycarbonyl)benzophenone, 3,3',4,4'-tetra(*t-*hexylperoxycarbonyl)benzophenone, 3,3',4,4'-tetra(*t-*octylperoxycarbonyl)benzophenone, 3,3',4,4'-tetra(cumylperoxycarbonyl)benzophenone, 3,3',4,4'-tetra(p-isopropylcumylperoxycarbonyl)benzophenone, di-*t*-butyldiperoxyisophthalate, *t-*butylperoxybenzoate, *t*-butylperoxy-3-methylbenzoate, *t*-butylperoxylaurate, *t-*butylperoxypivalate, *t*-butylperoxy-2-ethylhexanoate, *t-*butylperoxy-3,5,5-trimethylhexanoate, *t*-butylperoxyneoheptanoate, *t*-butylperoxyneodecanoate, and *t*-butylperoxyacetate, α,α'-di(*t*-butylperoxy)diisopropylbenzene, *t-*butylcumylperoxide, di-*t*-butylperoxide, *t*-butylperoxyisopropylmonocarbonate, and *t*-butylperoxy-2-ethylhexylmonocarbonate.

### (I) Azo compounds

Preferable (I) azo compounds as a polymerization initiator include those such as 2,2'-azobisisobutyronitrile, 2,2'-azobispropionitrile, 1,1'-azobis(cyclohexane-1-carbonitrile), 2,2'-azobis(2-methylbutyronitrile), 2,2'-azobis(2,4-dimethylvaleronitrile), 2,2'-azobis(4-methoxy-2,4-dimethylvaleronitrile), 4,4'-azobis(4-cyanovaleric acid), dimethyl 2,2'-azobis(isobutyrate), 2,2'-azobis(2-methylpropionamideoxime), 2,2'-azobis[2-(2-imidazolin-2-yl)propane], 2,2'-azobis{2-methyl-*N*-[1,1-bis(hydroxymethyl)-2-hydroxyethyl]propionamide}, 2,2'-azobis[2-methyl-*N*-(2-hydroxyethyl)propionamide], 2,2'-azobis(*N*-butyl-2-methylpropionamide), 2,2'-azobis(N-cyclohexyl-2-methylpropionamide), 2,2'-azobis[N-(2-propenyl)-2-methyl-propionamide], 2,2'-azobis(2,4,4-trimethylpentane).

In the present invention, the organic peroxide (c) is particularly preferable as the polymerization initiator in the present invention from the viewpoint of crosslinking properties of the film (relief-forming layer) and improving the engraving sensitivity.

From the viewpoint of the engraving sensitivity, an embodiment obtained by combining (c) an organic peroxide and a photothermal conversion agent described below is particularly preferable.

This is presumed as follows. When the relief-forming layer is cured by thermal crosslinking using an organic peroxide, an organic peroxide that did not play a part in radical generation and has not reacted remains, and the remaining organic peroxide works as an autoreactive additive and decomposes exothermally in laser engraving. As the result, energy of generated heat is added to the irradiated laser energy to thus raise the engraving sensitivity.

It will be described in detail in the explanation of photothermal converting agent, the effect thereof is remarkable when carbon black is used as the photothermal converting agent. It is considered that the heat generated from the carbon black is also transmitted to (c) an organic peroxide and, as the result, heat is generated not only from the carbon black but also from the organic peroxide, and that the generation of heat energy to be used for the decomposition of Component A etc. occurs synergistically.

Component C in the resin composition of the present invention may be used singly or in a combination of two or more compounds.

The content of Component C in the resin composition of the present invention is preferably 0.1 to 5 mass% relative to the total weight of the solids content, more preferably 0.3 to 3 mass%, and particularly preferably 0.5 to 1.5 mass%.

### (Component D) Photothermal conversion agent

The resin composition for laser engraving of the present invention preferably further includes a photothermal conversion agent. That is, it is considered that the photothermal conversion agent in the present invention can promote the thermal decomposition of a cured material during laser engraving by absorbing laser light and generating heat. Therefore, it is preferable that a photothermal conversion agent capable of absorbing light having a wavelength of laser used for graving be selected.

When a laser (a YAG laser, a semiconductor laser, a fiber laser, a surface emitting laser, etc.) emitting infrared at a wavelength of 700 to 1,300 nm is used as a light source for laser engraving, it is preferable for the flexographic printing plate precursor for laser engraving which is produced by using the resin composition for laser engraving of the present invention to comprise a photothermal conversion agent that has a maximun absorption wavelength at 700 to 1,300 nm.

As the photothermal conversion agent in the present invention, various types of dye or pigment are used.

With regard to the photothermal conversion agent, examples of dyes that can be used include commercial dyes and known dyes described in publications such as 'Senryo Binran' (Dye Handbook) (Ed. by The Society of Synthetic Organic Chemistry, Japan, 1970). Specific examples include dyes having a maximum absorption wavelength at 700 to 1,300 nm, and preferable examples include azo dyes, metal complex salt azo dyes, pyrazolone azo dyes, naphthoquinone dyes, anthraquinone dyes, phthalocyanine dyes, carbonium dyes, diimmonium compounds, quinone imine dyes, methine dyes, cyanine dyes, squarylium colorants, pyrylium salts, and metal thiolate complexes. In particular, cyanine-based colorants such as heptamethine cyanine colorants, oxonol-based colorants such as pentamethine oxonol colorants, and phthalocyanine-based colorants are preferably used. Examples include dyes described in paragraphs 0124 to 0137 of JP-A-2008-63554.

With regard to the photothermal conversion agent used in the present invention, examples of pigments include commercial pigments and pigments described in the Color Index (C.I.) Handbook, 'Saishin Ganryo Binran' (Latest Pigments Handbook) (Ed. by Nippon Ganryo Gijutsu Kyokai, 1977), 'Saishin Ganryo Ouyogijutsu' (Latest Applications of Pigment Technology) (CMC Publishing, 1986), 'Insatsu Inki Gijutsu' (Printing Ink Technology) (CMC Publishing, 1984). Examples of pigments include pigments described in paragraphs 0122 to 0125 of JP-A-2009-178869.

Among these pigments, carbon black is preferable.

Any carbon black, regardless of classification by ASTM (American Society for Testing and Materials) and application (e.g. for coloring, for rubber, for dry cell, etc.), may be used as long as dispersibility, etc. in the resin composition for laser engraving is stable. Examples of the carbon black include furnace black, thermal black, channel black, lamp black, and acetylene black. In order to make dispersion easy, a black colorant such as carbon black may be used as color chips or a color paste by dispersing it in nitrocellulose or a binder in advance using, as necessary, a dispersant, and such chips and paste are readily available as commercial products. Examples of carbon black include carbon blacks described in paragraphs 0130 to 0134 of JP-A-2009-178869.

Component D in the resin composition of the present invention may be used singly or in a combination of two or more compounds.

The content of the photothermal conversion agent in the resin composition for laser engraving of the present invention may vary greatly with the magnitude of the molecular extinction coefficient inherent to the molecule, but the content is preferably 0.01 to 30 mass%, more preferably 0.05 to 20 mass%, and particularly preferably 0.1 to 10 mass%, relative to the total solids content by mass of the resin composition.

### (Component E) Compound comprising at least one type from a hydrolyzable silyl group and a silanol group

With regard to a (Component E) a compound comprising at least one type from a hydrolyzable silyl group and a silanol group (hereinafter, called as appropriate a 'Component E') preferably used in the resin composition for laser engraving of the present invention, the 'hydrolyzable silyl group' means a silyl group having hydrolyzability, examples of the hydrolyzable group include an alkoxy group, a mercapto group, a halogen atom, an amide group, an acetoxy group, an amino group, and an isopropenoxy group.

A silyl group undergoes hydrolysis to become a silanol group, and a resulting silanol group undergoes dehydration-condensation to form a siloxane bond. Such a hydrolyzable silyl group and/or silanol group is preferably represented bv Formula (1).

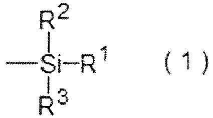

In Formula (1) above, at least one of R¹ to R³ denotes a hydrolyzable group selected from the group consisting of an alkoxy group, a mercapto group, a halogen atom, an amide group, an acetoxy group, an amino group, and an isopropenoxy group, or a hydroxy group. The remainder of R¹ to R³ independently denotes a hydrogen atom, a halogen atom, or a monovalent organic substituent (examples including an alkyl group, an aryl group, an alkenyl group, an alkynyl group, and an aralkyl group).

In Formula (1) above, the hydrolyzable group bonded to the silicon atom is particularly preferably an alkoxy group or a halogen atom, and more preferably an alkoxy group.

From the viewpoint of rinsing properties and printing durability, the alkoxy group is preferably an alkoxy group having 1 to 30 carbon atoms, more preferably an alkoxy group having 1 to 15 carbon atoms, yet more preferably having 1 to 5 carbon atoms, particularly preferably an alkoxy group having 1 to 3 carbon atoms, and most preferably a methoxy group or an ethoxy group.

Furthermore, examples of the halogen atom include an F atom, a Cl atom, a Br atom, and an I atom, and from the viewpoint of ease of synthesis and stability it is preferably a Cl atom or a Br atom, and more preferably a Cl atom.

Component E in the present invention is preferably a compound having one or more groups represented by Formula (1) above, and more preferably a compound having two or more. A compound having two or more hydrolyzable silyl groups is particularly preferably used. That is, a compound having in the molecule two or more silicon atoms having a hydrolyzable group bonded thereto is preferably used. The number of silicon atoms having a hydrolyzable group bond thereto is preferably at least 2 but no greater than 6, and most preferably 2 or 3.

A range of 1 to 4 of the hydrolyzable groups may bond to one silicon atom, and the total number of hydrolyzable groups in Formula (1) is preferably in a range of 2 or 3. It is particularly preferable that three hydrolyzable groups are bonded to a silicon atom. When two or more hydrolyzable groups are bonded to a silicon atom, they may be identical to or different from each other.

Specific preferred examples of the alkoxy group include a methoxy group, an ethoxy group, a propoxy group, an isopropoxy group, a butoxy group, a *tert*-butoxy group, a phenoxy group, and a benzyloxy group. A plurality of each of these alkoxy groups may be used in combination, or a plurality of different alkoxy groups may be used in combination.

Examples of the alkoxysilyl group having an alkoxy group bonded thereto include a trialkoxysilyl group such as a trimethoxysilyl group, a triethoxysilyl group, a triisopropoxysilyl group, or a triphenoxysilyl group; a dialkoxymonoalkylsilyl group such as a dimethoxymethylsilyl group or a diethoxymethylsilyl group; and a monoalkoxydialkylsilyl group such as a methoxydimethylsilyl group or an ethoxydimethylsilyl group.

Component E preferably has at least a sulfur atom, an ester bond, a urethane bond, an ether bond, a urea bond, or an imino group.

Among them, from the viewpoint of crosslinkability, Component E preferably comprises a sulfur atom, and from the viewpoint of removability (rinsing properties) of engraving residue it is preferable for it to comprise an ester bond, a urethane bond, or an ether bond (in particular, an ether bond contained in an oxyalkylene group), which is easily decomposed by aqueous alkali. Component E containing a sulfur atom functions as a vulcanizing agent or a vulcanization accelerator when carrying out a vulcanization treatment, thus promoting a reaction (crosslinking) of a conjugated diene monomer unit-containing polymer. As a result, the rubber elasticity necessary as a printing plate is exhibited. Furthermore, the strength of a crosslinked relief-forming layer and a relief layer is improved.

Furthermore, from the viewpoint of engraving residue rinsing properties and scattering inhibition, Component E preferably comprises an isocyanurate structure (a s-triazine-2,4,6-trione structure).

Furthermore, Component E is preferably the compound that does not comprise an ethylenically unsaturated group.

As Component E in the present invention, there can be cited a compound in which a plurality of groups represented by Formula (1) above are bonded via a divalent linking group, and from the viewpoint of the effect, such a divalent linking group is preferably a linking group having a sulfide group (-S-), an imino group (-N(R)-) a urea group or a urethane bond (-OCON(R)- or - N(R)COO-). R denotes a hydrogen atom or a substituent. Examples of the substituent denoted by R include an alkyl group, an aryl group, an alkenyl group, an alkynyl group, and an aralkyl group.

A method for synthesizing the Component E is not particularly limited, and synthesis can be carried out by a known method. Examples of the method include a method described in paragraphs 0019 to 0021 of JP-A-2011-136429.

Component E is preferably a compound represented by Formula (E-A-1) or Formula (E-A-2) below.

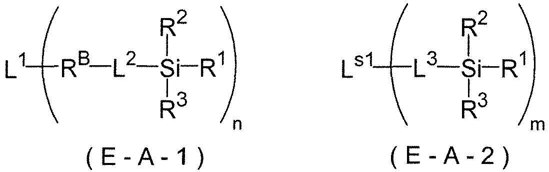

In Formula (E-A-1) and Formula (E-A-2), R^{B} denotes an ester bond, an amide bond, a urethane bond, a urea bond, or an imino group, L¹ denotes an n-valent linking group, L² denotes a divalent linking group, L^{s1} denotes an m-valent linking group, L³ denotes a divalent linking group, n and m independently denote an integer of 1 or greater, and R¹ to R³ independently denote a hydrogen atom, a halogen atom, or a monovalent organic substituent. In addition, at least one of R¹ to R³ denotes a hydrolyzable group selected from the group consisting of an alkoxy group, a mercapto group, a halogen atom, an amide group, an acetoxy group, an amino group, and an isopropenoxy group, or a hydroxy group.

R¹ to R³ in Formula (E-A-1) and Formula (E-A-2) above have the same meanings as those of R¹ to R³ in Formula (1) above, and preferred ranges are also the same.

From the viewpoint of rinsing properties and film strength, R^{B} above is preferably an ester bond or a urethane bond, and is more preferably an ester bond.

The divalent or n-valent linking group denoted by L¹ to L³ above is preferably a group formed from at least one type of atom selected from the group consisting of a carbon atom, a hydrogen atom, an oxygen atom, a nitrogen atom, and a sulfur atom, and is more preferably a group formed from at least one type of atom selected from the group consisting of a carbon atom, a hydrogen atom, an oxygen atom, and a sulfur atom. The number of carbon atoms of L¹ to L³ above is preferably 2 to 60, and more preferably 2 to 30.

The m-valent linking group denoted by L^{s1} above is preferably a group formed from a sulfur atom and at least one type of atom selected from the group consisting of a carbon atom, a hydrogen atom, an oxygen atom, a nitrogen atom, and a sulfur atom, and is more preferably an alkylene group or a group formed by combining two or more from an alkylene group, a sulfide group, and an imino group. The number of carbon atoms of L^{s1} above is preferably 2 to 60, and more preferably 6 to 30.

n and m above are preferably and independently integers of 1 to 10, more preferably integers of 2 to 10, yet more preferably integers of 2 to 6, and particularly preferably 2.

From the viewpoint of removability (rinsing properties) of engraving residue, the n-valent linking group denoted by L¹ and/or the divalent linking group denoted by L², or the divalent linking group denoted by L³ preferably has an ether bond, and more preferably has an ether bond contained in an oxyalkylene group.

Among compounds represented by Formula (E-A-1) or Formula (E-A-2), from the viewpoint of crosslinkability, etc., the n-valent linking group denoted by L¹ and/or the divalent linking group denoted by L² in Formula (E-A-1) are preferably groups having a sulfur atom.

Component E is preferably a compound having at least an alkoxy group on the silicon atom of a silyl group, more preferably a compound having two alkoxy groups on the silicon atom of a silyl group, and yet more preferably a compound having three alkoxy group on the silicon atom of a silyl group.

Furthermore, specific examples of Component E include compounds described in paragraphs 0025 to 0037 of JP-A-2011-136429.

With regard to Component E in the composition for laser engraving, one type thereof may be used on its own or two or more types may be used in combination.

The content of Component E in the composition for laser engraving is preferably in the range of 0.1 to 80 mass% on a solids content basis, more preferably in the range of 1 to 40 mass%, and yet more preferably in the range of 5 to 30 mass%.

### (Component F) Alcohol exchange reaction catalyst

When the composition for laser engraving that can be used in the present invention comprises Component E, in order to promote a reaction between Component E and a specific binder polymer, it is preferable for it to comprise (Component F) an alcohol exchange reaction catalyst.

The alcohol exchange reaction catalyst may be used without any limitation as long as it is a commonly used reaction catalyst.

An acid or base catalyst and a metal complex catalyst, which are representative alcohol exchange reaction catalysts, are explained below in sequence.

### Acidic or basic catalyst

As the catalyst, an acidic or a basic compound is prefferably used as it is or in the form of a solution in which it is dissolved in a solvent such as water or an organic solvent (hereinafter, called an acidic catalyst or a basic catalyst). The concentration when dissolved in a solvent is not particularly limited, and it may be selected appropriately according to the properties of the acidic or basic compound used, desired catalyst content, etc.

The type of the acidic or basic catalyst is not limited, and examples of the acidic catalyst include halogenated hydrogen such as hydrochloric acid, nitric acid, sulfuric acid, sulfurous acid, hydrogen sulfide, perchloric acid, hydrogen peroxide, carbonic acid, carboxylic acids such as formic acid and acetic acid, substituted carboxylic acids in which R of a structural formula represented by RCOOH is substituted by another element or substituent, sulfonic acids such as benzenesulfonic acid, phosphoric acid, etc, and examples of the basic catalyst include an ammoniacal base such as aqueous ammonia, an amine such as ethyl amine and aniline etc. Among these, from the viewpoint of progressing fastly an alcohol exchange reaction in the layer, methanesulfonic acid, *p*-toluenesulfonic acid, pyridinium-*p*-toluene sulfonate, phosphoric acid, phosphonic acid, acetic acid, 1,8-diazabicyclo[5.4.0]undec-7-ene, and hexamethylenetetramine are preferable, methanesulfonic acid, p-toluenesulfonic acid, phosphoric acid, 1,8-diazabicyclo[5.4.0]undec-7-ene, and hexamethylenetetramine are particularly preferable.

### Metal complex catalyst

The metal complex catalyst that can be used as an alcohol exchange reaction catalyst in the present invention is preferably constituted from a metal element selected from Groups 2, 4, 5, and 13 of the periodic table and an oxo or hydroxy oxygen compound selected from β-diketones (acetylacetone is preferable), ketoesters, hydroxycarboxylic acids and esters thereof, amino alcohols, and enolic active hydrogen compounds.

Furthermore, among the constituent metal elements, a Group 2 element such as Mg, Ca, St, or Ba, a Group 4 element such as Ti or Zr, a Group 5 element such as V, Nb, or Ta, and a Group 13 element such as Al or Ga are preferable, and they form a complex having an excellent catalytic effect. Among them, a complex obtained from Zr, Al, or Ti is excellent and preferable, and more preferred examples of the metal complex catalyst include ethyl orthotitanate, etc.

These metal complex catalysts are excellent in terms of stability in an aqueous coating solution and an effect in promoting gelling in a sol-gel reaction when thermally drying, and among them, ethyl acetoacetate aluminum diisopropylate, aluminum tris(ethyl acetoacetate), a di(acetylacetonato)titanium complex salt, and zirconium tris(ethyl acetoacetate) are particularly preferable.

With regard to the composition for laser engraving, one type of alcohol exchange reaction catalyst may be used on its own or two or more types thereof may be used in combination. The content of the alcohol exchange reaction catalyst in the composition is preferably 0.01 to 20 mass% relative to the specific hydroxy group-containing binder polymer, and more preferably 0.1 to 10 mass%.

### (Component G) Plasticizer

The resin composition for laser engraving of the present invention may comprise a plasticizer.

A plasticizer has the function of softening a film formed from the resin composition for laser engraving, and it is necessary for it to be compatible with a binder polymer.

Preferred examples of the plasticizer include dioctyl phthalate, didodecyl phthalate, bisbutoxyethyl adipate, a polyethylene glycol, a polypropylene glycol (monool type or diol type), and a polypropylene glycol (monool type or diol type).

With regard to Component G in the resin composition of the present invention, one type thereof may be used on its own or two or more types may be used in combination.

From the viewpoint of maintaining flexible film physical properties, the content of the plasticizer in the resin composition for laser engraving of the present invention is preferably no greater than 50 mass% of the entire solids content concentration, more preferably no greater than 30 mass%, yet more preferably no greater than 10 mass%, and particularly preferably none.

### (Component H) Solvent

It is preferably to use (Component H) a solvent when preparing the resin composition for laser engraving of the present invention.

As the solvent, an organic solvent is preferably used.

Specific preferred examples of the aprotic organic solvent include acetonitrile, tetrahydrofuran, dioxane, toluene, propylene glycol monomethyl ether acetate, methyl ethyl ketone, acetone, methyl isobutyl ketone, ethyl acetate, butyl acetate, ethyl lactate, N*,N-*dimethylacetamide, *N-*methylpyrrolidone, and dimethyl sulfoxide.

Specific preferred examples of the protic organic solvent include methanol, ethanol, 1-propanol, 2-propanol, 1-butanol, 1-methoxy-2-propanol, ethylene glycol, diethylene glycol, and 1,3-propanediol.

Among these, propylene glycol monomethyl ether acetate is preferable.

The content of the solvent is not particularly limited, and the content necessary for forming a relief-forming layer, etc. may be added. Meanwhile, the solids content of the resin composition means the content except for the solvent in the resin composition.

### <Other additives>

The resin composition for laser engraving of the present invention may comprise as appropriate various types of known additives as long as the effects of the present invention are not inhibited. Examples include a chain transfer agent, a filler, a wax, a fragrance, an ultraviolet absorbent, a glidant, a lubricant, a process oil, an a metal oxide, an antiozonant, an anti-aging agent, a thermopolymerization inhibitor, and a colorant, and one type thereof may be used on its own or two more types may be used in combination.

The chain transfer agent is not particularly limited, but a mercapto compound can be cited as a preferred example. It is surmised that among compounds described above for Component E, one comprising a mercapto group also functions as a chain transfer agent.

As the filler, inorganic particles can be cited.

The inorganic particles preferably have a number-average particle size of at least 0.01 µm but no greater than 10 µm. Furthermore, the inorganic particles are preferably porous particles or nonporous particles.

The porous particles referred to here are defined as particles having fine pores having a pore volume of at least 0.1 mL/g in the particle or particles having fine cavities.

The porous particles preferably have a specific surface area of at least 10 m²/g but no greater than 1,500 m²/g, an average pore diameter of at least 1 nm but no greater than 1,000 nm, a pore volume of at least 0.1 mL/g but no greater than 10 mL/g, and an oil adsorption of at least 10 mL/100 g but no greater than 2,000 mL/100 g. The specific surface area is determined based on the BET equation from the adsorption isotherm of nitrogen at -196°C. Furthermore, measurement of the pore volume and the average pore diameter preferably employs a nitrogen adsorption method. Measurement of the oil adsorption may be suitably carried out in accordance with JIS-K5101.

The number-average particle size of the porous particles is preferably at least 0.01 µm but no greater than 10 µm, more preferably at least 0.5 µm but no greater than 8 µm, and yet more preferably at least 1 µm but no greater than 5 µm.

The shape of the porous particles is not particularly limited, and spherical, flat-shaped, needle-shaped, or amorphous particles, or particles having projections on the surface, etc. may be used.

Furthermore, particles having a cavity in the interior, spherical granules having a uniform pore diameter such as a silica sponge, etc. may be used. Examples thereof are not particularly limited but include porous silica, mesoporous silica, a silica-zirconia porous gel, porous alumina, and a porous glass. Furthermore, as for a layered clay compound, pore diameter cannot be defined for those having a cavity of a few nm to a few hundred nm between layers, and in the present embodiment the distance between cavities present between layers is defined as the pore diameter.

Moreover, particles obtained by subjecting the surface of porous particles to a surface modifying treatment by covering with a silane coupling agent, a titanium coupling agent, or another organic compound so as to make the surface hydrophilic or hydrophobic may also be used. With regard to these porous particles, one type or two or more types may be selected.

The nonporous particles are defined as particles having a pore volume of less than 0.1 mL/g. The number-average particle size of the nonporous particles is the number-average particle size for primary particles as the target, and is preferably at least 10 nm but no greater than 500 nm, and more preferably at least 10 nm but no greater than 100 nm.

The amount of filler added is not particularly limited, but is preferably 1 to 100 parts by mass relative to 100 parts by mass of Component A.

### (flexographic printing plate precursor for laser engraving)

A first embodiment of the flexographic printing plate precursor for laser engraving of the present invention comprises a relief-forming layer formed from the resin composition for laser engraving of the present invention.

A second embodiment of the flexographic printing plate precursor for laser engraving of the present invention comprises a crosslinked relief-forming layer formed by crosslinking a relief-forming layer formed from the resin composition for laser engraving of the present invention.

In the present invention, the 'flexographic printing plate precursor for laser engraving' means both or one of a flexographic printing plate precursor having a crosslinkable relief-forming layer formed from the resin composition for laser engraving in a state before being crosslinked and a flexographic printing plate precursor in a state in which it is cured by light or heat.

The flexographic printing plate precursor for laser engraving of the present invention is a flexographic printing plate precursor having a crosslinkable relief-forming layer cured by heat.

In the present invention, the 'relief-forming layer' means a layer in a state before being crosslinked, that is, a layer formed from the resin composition for laser engraving of the present invention, which may be dried as necessary.

In the present invention, the "crosslinked relief-forming layer" refers to a layer obtained by crosslinking the aforementioned relief-forming layer. The crosslinking can be performed by light and/or heat, and the crosslinking by heat is preferable. Moreover, the crosslinking is not particularly limited only if it is a reaction that cures the resin composition, and is a general idea that includes the crosslinked structure by the reaction of Component A with each other, and the reaction of Component A with other Component. When a polymerizable compound is used, the crosslinking includes a crosslinking by polymerization of polymerizable compounds.

The 'flexsographic printing plate' is made by laser engraving the flexographic printing plate precursor having the crosslinked relief-forming layer.

Moreover, in the present invention, the 'relief layer' means a layer of the flexographic printing plate formed by engraving using a laser, that is, the crosslinked relief-forming layer after laser engraving.

A flexographic printing plate precursor for laser engravingof the present invention comprises a relief-forming layer formed from the resin composition for laser engraving of the present invention, which has the above-mentioned components. The (crosslinked) relief-forming layer is preferably provided above a support.

The (crosslinked) flexographic printing plate precursor for laser engraving may further comprise, as necessary, an adhesive layer between the support and the (crosslinked) relief-forming layer and, above the relief-forming layer, a slip coat layer and a protection film.

### <Relief-forming layer>

The relief-forming layer is a layer formed from the resin composition for laser engraving of the present invention, and is a crosslinkable layer.

As a mode in which a flexographic printing plate is prepared using the flexographic printing plate precursor for laser engraving, a mode in which a flexographic printing plate is prepared by crosslinking a relief-forming layer to thus form a flexographic printing plate precursor having a crosslinked relief-forming layer, and the crosslinked relief-forming layer (hard relief-forming layer) is then laser-engraved to thus form a relief layer is preferable. By crosslinking the relief-forming layer, it is possible to prevent abrasion of the relief layer during printing, and it is possible to obtain a flexographic printing plate having a relief layer with a sharp shape after laser engraving.

The relief-forming layer may be formed by molding the resin composition for laser engraving that has the above-mentioned components for a relief-forming layer into a sheet shape or a sleeve shape. The relief-forming layer is usually provided above a support, which is described later, but it may be formed directly on the surface of a member such as a cylinder of equipment for plate producing or printing or may be placed and immobilized thereon, and a support is not always required.

A case in which the relief-forming layer is mainly formed in a sheet shape is explained as an example below.

### <Support>

A material used for the support of the flexographic printing plate precursor for laser engraving is not particularly limited, but one having high dimensional stability is preferably used, and examples thereof include metals such as steel, stainless steel, or aluminum, plastic resins such as a polyester (e.g. polyethylene terephthalate (PET), polybutylene terephthalate (PBT), or polyacrylonitrile (PAN)) or polyvinyl chloride, synthetic rubbers such as styrene-butadiene rubber, and glass fiber-reinforced plastic resins (epoxy resin, phenolic resin, etc.). As the support, a PET film or a steel substrate is preferably used. The configuration of the support depends on whether the relief-forming layer is in a sheet shape or a sleeve shape.

### <Adhesive layer>

An adhesive layer may be provided between the relief-forming layer and the support for the purpose of strengthening the adhesion between the two layers. Examples of materials (adhesives) that can be used in the adhesive layer include those described in 'Handbook of Adhesives', Second Edition, Ed by I. Skeist, (1977).

### <Protection film, slip coat layer>

For the purpose of preventing scratches or dents in the relief-forming layer surface or the crosslinked relief-forming layer surface, a protection film may be provided on the relief-forming layer surface or the crosslinked relief-forming layer surface. The thickness of the protection film is preferably 25 to 500 µm, and more preferably 50 to 200 µm. The protection film may employ, for example, a polyester-based film such as PET or a polyolefin-based film such as PE (polyethylene) or PP (polypropylene). The surface of the film may be made matte. The protection film is preferably peelable.

When the protection film is not peelable or conversely has poor adhesion to the relief-forming layer, a slip coat layer may be provided between the two layers. The material used in the slip coat layer preferably employs as a main component a resin that is soluble or dispersible in water and has little tackiness, such as polyvinyl alcohol, polyvinyl acetate, partially saponified polyvinyl alcohol, a hydroxyalkylcellulose, an alkylcellulose, or a polyamide resin.

### <Process for producing flexographic printing plate precursor for laser engraving>

A method for forming a relief-forming layer in the flexographic printing plate precursor for laser engraving is not particularly limited, and examples thereof include a method in which a resin composition for laser engraving is prepared, solvent is removed, as necessarily, from this coating solution composition for laser engraving, and it is then melt-extruded onto a support. Alternatively, a method may be employed in which a resin composition for laser engraving is cast onto a support, and this is dried in an oven to thus remove solvent from the resin composition.

Among them, the process for producing a flexographic printing plate precursor for laser engraving of the present invention is preferably a production process comprising a layer formation step of forming a relief-forming layer from the resin composition for laser engraving of the present invention and a crosslinking step of crosslinking the relief-forming layer by means of heat and/or light to thus obtain a flexographic printing plate precursor having a crosslinked relief-forming layer, and more preferably a production process comprising a layer formation step of forming a relief-forming layer from the resin composition for laser engraving of the present invention and a crosslinking step of crosslinking the relief-forming layer by means of heat to thus obtain a flexographic printing plate precursor having a crosslinked relief-forming layer.

Subsequently, as necessary, a protection film may be laminated on the relief-forming layer. Laminating may be carried out by compression-bonding the protection film and the relief-forming layer by means of heated calendar rollers, etc. or putting a protection film into intimate contact with a relief-forming layer whose surface is impregnated with a small amount of solvent.

When a protection film is used, a method in which a relief-forming layer is first layered on a protection film and a support is then laminated may be employed.

When an adhesive layer is provided, it may be dealt with by use of a support coated with an adhesive layer. When a slip coat layer is provided, it may be dealt with by use of a protection film coated with a slip coat layer.

### <Layer formation step>

The process for producing the flexographic printing plate precursor for laser engraving of the present invention preferably comprises a layer formation step of forming a relief-forming layer from the resin composition for laser engraving of the present invention.

Preferred examples of a method for forming the relief-forming layer include a method in which the resin composition for laser engraving of the present invention is prepared, solvent is removed as necessary from this resin composition for laser engraving, and it is then melt-extruded onto a support and a method in which the resin composition for laser engraving of the present invention is prepared, the resin composition for laser engraving of the present invention is cast onto a support, and this is dried in an oven to thus remove solvent.

The resin composition for laser engraving may be produced by, for example, dissolving or dispersing Components A and B, and optional components in an appropriate solvent, and then dissolving or dispersing Component C.

The thickness of the (crosslinked) relief-forming layer in the flexographic printing plate precursor for laser engraving is preferably 0.05 to 10 mm before and after crosslinking, more preferably 0.05 to 7 mm, and yet more preferably 0.05 to 3 mm.

### <Crosslinking step>

The process for producing a flexographic printing plate precursor for laser engraving of the present invention is preferably a production process comprising a crosslinking step of crosslinking the relief-forming layer by means of heat to thus obtain a flexographic printing plate precursor having a crosslinked relief-forming layer.

When the relief-forming layer comprises a photopolymerization initiator, the relief-forming layer may be crosslinked by irradiating the relief-forming layer with actinic radiation that triggers the photopolymerization initiator.

It is preferable to apply light to the entire surface of the relief-forming layer. Examples of the light (also called 'actinic radiation') include visible light, UV light, and an electron beam, but UV light is most preferably used. When the side where there is a substrate, such as a relief-forming layer support, for fixing the relief-forming layer, is defined as the reverse face, only the front face need to be irradiated with light, but when the support is a transparent film through which actinic radiation passes, it is preferable to further irradiate from the reverse face with light as well. When a protection film is present, irradiation from the front face may be carried out with the protection film as it is or after peeling off the protection film. Since there is a possibility of polymerization being inhibited in the presence of oxygen, irradiation with actinic radiation may be carried out after superimposing a polyvinyl chloride sheet on the relief-forming layer and evacuating.

When the relief-forming layer comprises thermal polymerization initiator (the photopolymerization initiator can also be a thermal polymerization initiator.), the relief-forming layer may be crosslinked by heating the flexographic printing plate precursor for laser engraving (step of crosslinking by means of heat). As heating means for carrying out crosslinking by heat, there can be cited a method in which a printing plate precursor is heated in a hot air oven or a far-infrared oven for a predetermined period of time and a method in which it is put into contact with a heated roller for a predetermined period of time.

As a method for crosslinking the relief-forming layer, from the viewpoint of the relief-forming layer being uniformly curable (crosslinkable) from the surface into the interior, crosslinking by heat is preferable.

Due to the relief-forming layer being crosslinked, firstly, a relief formed after laser engraving becomes sharp and, secondly, tackiness of engraving residue formed when laser engraving is suppressed. If an uncrosslinked relief-forming layer is laser-engraved, residual heat transmitted to an area around a laser-irradiated part easily causes melting or deformation of a part that is not targeted, and a sharp relief layer cannot be obtained in some cases. Furthermore, in terms of general properties of a material, the lower the molecular weight, the more easily it becomes a liquid than a solid, that is, there is a tendency for tackiness to increase. Engraving residue formed when engraving a relief-forming layer tends to have higher tackiness as larger amounts of low-molecular-weight materials are used. Since a polymerizable compound, which is a low-molecular-weight material, becomes a polymer by crosslinking, the tackiness of the engraving residue formed tends to decrease. When the crosslinking step is a step of carrying out crosslinking by light, although equipment for applying actinic radiation is relatively expensive, since a printing plate precursor does not reach a high temperature, there are hardly any restrictions on starting materials for the printing plate precursor.

When the crosslinking step is a step of carrying out crosslinking by heat, although there is the advantage that particularly expensive equipment is not needed, since a printing plate precursor reaches a high temperature, it is necessary to carefully select the starting materials used while taking into consideration the possibility that a thermoplastic polymer, which becomes soft at high temperature, will deform during heating, etc.

During thermal crosslinking, it is preferable to add a thermopolymerization initiator. As the thermopolymerization initiator, a commercial thermopolymerization initiator for free radical polymerization may be used. Examples of such a thermopolymerization initiator include an appropriate peroxide, hydroperoxide, and azo group-containing compound. A representative vulcanizing agent may also be used for crosslinking. Thermal crosslinking may also be carried out by adding a heat-curable resin such as for example an epoxy resin as a crosslinking component to a layer.

### (Flexographic printing plate and process for making same)

The process for making a flexographic printing plate of the present invention preferably comprises a layer formation step of forming a relief-forming layer from the resin composition for laser engraving of the present invention, a crosslinking step of crosslinking the relief-forming layer by means of heat and/or light to thus obtain a flexographic printing plate precursor having a crosslinked relief-forming layer, and an engraving step of laser-engraving the flexographic printing plate precursor having the crosslinked relief-forming layer, and more preferably comprises a layer formation step of forming a relief-forming layer from the resin composition for laser engraving of the present invention, a crosslinking step of crosslinking the relief-forming layer by means of heat to thus obtain a flexographic printing plate precursor having a crosslinked relief-forming layer, and an engraving step of laser-engraving the flexographic printing plate precursor having the crosslinked relief-forming layer.

The flexographic printing plate of the present invention is a flexographic printing plate having a relief layer obtained by crosslinking and laser-engraving a layer formed from the resin composition for laser engraving of the present invention, and is preferably a flexographic printing plate made by the process for producing a flexographic printing plate of the present invention.

The flexographic printing plate of the present invention may suitably employ an aqueous ink when printing.

The layer formation step and the crosslinking step in the process for producing a flexographic printing plate of the present invention mean the same as the layer formation step and the crosslinking step in the above-mentioned process for producing a flexographic printing plate precursor for laser engraving , and preferred ranges are also the same.

### <Engraving step>

The process for producing a flexographic printing plate of the present invention preferably comprises an engraving step of laser-engraving the flexographic printing plate precursor having a crosslinked relief-forming layer.

The engraving step is a step of laser-engraving a crosslinked relief-forming layer that has been crosslinked in the crosslinking step to thus form a relief layer. Specifically, it is preferable to engrave a crosslinked relief-forming layer that has been crosslinked with laser light according to a desired image, thus forming a relief layer. Furthermore, a step in which a crosslinked relief-forming layer is subjected to scanning irradiation by controlling a laser head using a computer in accordance with digital data of a desired image can preferably be cited.

This engraving step preferably employs an infrared laser. When irradiated with an infrared laser, molecules in the crosslinked relief-forming layer undergo molecular vibration, thus generating heat. When a high power laser such as a carbon dioxide laser or a YAG laser is used as the infrared laser, a large quantity of heat is generated in the laser-irradiated area, and molecules in the crosslinked relief-forming layer undergo molecular scission or ionization, thus being selectively removed, that is, engraved. The advantage of laser engraving is that, since the depth of engraving can be set freely, it is possible to control the structure three-dimensionally. For example, for an area where fine halftone dots are printed, carrying out engraving shallowly or with a shoulder prevents the relief from collapsing due to printing pressure, and for a groove area where a fine outline character is printed, carrying out engraving deeply makes it difficult for ink the groove to be blocked with ink, thus enabling breakup of an outline character to be suppressed.

In particular, when engraving is carried out using an infrared laser that corresponds to the absorption wavelength of the photothermal conversion agent, it becomes possible to selectively remove the crosslinked relief-forming layer at higher sensitivity, thus giving a relief layer having a sharp image.

As the infrared laser used in the engraving step, from the viewpoint of productivity, cost, etc., a carbon dioxide laser (a CO₂ laser) or a semiconductor laser is preferable. In particular, a fiber-coupled semiconductor infrared laser (FC-LD) is preferably used. In general, compared with a CO₂ laser, a semiconductor laser has higher efficiency laser oscillation, is less expensive, and can be made smaller. Furthermore, it is easy to form an array due to the small size. Moreover, the shape of the beam can be controlled by treatment of the fiber.

With regard to the semiconductor laser, one having a wavelength of 700 to 1,300 nm is preferable, one having a wavelength of 800 to 1,200 nm is more preferable, one having a wavelength of 860 to 1,200 nm is yet more preferable, and one having a wavelength of 900 to 1,100 nm is particularly preferable.

Furthermore, the fiber-coupled semiconductor laser can output laser light efficiently by being equipped with optical fiber, and this is effective in the engraving step in the present invention. Moreover, the shape of the beam can be controlled by treatment of the fiber. For example, the beam profile may be a top hat shape, and energy can be applied stably to the plate face. Details of semiconductor lasers are described in 'Laser Handbook 2^{nd} Edition' The Laser Society of Japan, Applied Laser Technology, The Institute of Electronics and Communication Engineers, etc.

Moreover, as plate making equipment comprising a fiber-coupled semiconductor laser that can be used suitably in the process for making a flexographic printing plate employing the flexographic printing plate precursor of the present invention, those described in detail in JP-A-2009-172658 and JP-A-2009-214334 can be cited. Such equipment comprising a fiber-coupled semiconductor laser can be used to produce a flexographic printing plate of the present invention.

The process for producing a flexographic printing plate of the present invention may as necessary further comprise, subsequent to the engraving step, a rinsing step, a drying step, and/or a post-crosslinking step, which are shown below.

Rinsing step: a step of rinsing the engraved surface by rinsing the engraved relief layer surface with water or a liquid comprising water as a main component.

Drying step: a step of drying the engraved relief layer.

Post-crosslinking step: a step of further crosslinking the relief layer by applying energy to the engraved relief layer.

After the above-mentioned step, since engraved residue is attached to the engraved surface, a rinsing step of washing off engraved residue by rinsing the engraved surface with water or a liquid comprising water as a main component may be added. Examples of rinsing means include a method in which washing is carried out with tap water, a method in which high pressure water is spray-jetted, and a method in which the engraved surface is brushed in the presence of mainly water using a batch or conveyor brush type washout machine known as a photosensitive resin letterpress plate processor, and when slime due to engraved residue cannot be eliminated, a rinsing liquid to which a soap or a surfactant is added may be used.

When the rinsing step of rinsing the engraved surface is carried out, it is preferable to add a drying step of drying an engraved relief-forming layer so as to evaporate rinsing liquid.

Furthermore, as necessary, a post-crosslinking step for further crosslinking the relief-forming layer may be added. By carrying out a post-crosslinking step, which is an additional crosslinking step, it is possible to further strengthen the relief formed by engraving.

The pH of the rinsing liquid that can be used in the present invention is preferably at least 9, more preferably at least 10, and yet more preferably at least 11. The pH of the rinsing liquid is preferably no greater than 14, more preferably no greater than 13.5, and yet more preferably no greater than 13.2. When in the above-mentioned range, handling is easy.

In order to set the pH of the rinsing liquid in the above-mentioned range, the pH may be adjusted using an acid and/or a base as appropriate, and the acid or base used is not particularly limited.

The rinsing liquid that can be used in the present invention preferably comprises water as a main component.

The rinsing liquid may contain as a solvent other than water a water-miscible solvent such as an alcohol, acetone, or tetrahydrofuran.

Furthermore, since the flexographic printing plate of the present invention has excellent engraving residue rinsing properties, water can be preferably used as the rinsing liquid.

The rinsing liquid preferably comprises a surfactant.

From the viewpoint of removability of engraved residue and little influence on a flexographic printing plate, preferred examples of the surfactant that can be used in the present invention include betaine compounds (amphoteric surfactants) such as a carboxybetaine compound, a sulfobetaine compound, a phosphobetaine compound, an amine oxide compound, and a phosphine oxide compound.

Furthermore, examples of the surfactant also include known anionic surfactants, cationic surfactants, amphoteric surfactants and nonionic surfactants. Moreover, a fluorine-based or silicone-based nonionic surfactant may also be used in the same manner.

With regard to the surfactant, one type may be used on its own or two or more types may be used in combination.

It is not necessary to particularly limit the amount of surfactant used, but it is preferably 0.01 to 20 mass% relative to the total mass of the rinsing liquid, and more preferably 0.05 to 10 mass%.

The flexographic printing plate of the present invention having a relief layer above the surface of an optional substrate such as a support may be produced as described above.

From the viewpoint of satisfying suitability for various aspects of printing, such as abrasion resistance and ink transfer properties, the thickness of the relief layer of the flexographic printing plate is preferably at least 0.05 mm but no greater than 10 mm, more preferably at least 0.05 mm but no greater than 7 mm, and yet more preferably at least 0.05 mm but no greater than 3 mm.

Furthermore, the Shore A hardness of the relief layer of the flexographic printing plate is preferably at least 50° but no greater than 90°. When the Shore A hardness of the relief layer is at least 50°, even if fine halftone dots formed by engraving receive a strong printing pressure from a letterpress printer, they do not collapse and close up, and normal printing can be carried out. Furthermore, when the Shore A hardness of the relief layer is no greater than 90°, even for flexographic printing with kiss touch printing pressure it is possible to prevent patchy printing in a solid printed part.

The Shore A hardness in the present specification is a value measured by a durometer (a spring type rubber hardness meter) that presses an indenter (called a pressing needle or indenter) into the surface of a measurement target at 25°C so as to deform it, measures the amount of deformation (indentation depth), and converts it into a numerical value.

The flexographic printing plate of the present invention is particularly suitable for printing by a flexographic printer using an aqueous ink, but printing is also possible when it is carried out by a letterpress printer using any of aqueous, oil-based, and UV inks, and printing is also possible when it is carried out by a flexographic printer using a UV ink. The flexographic printing plate of the present invention has excellent rinsing properties, there is no engraved residue, the flexographic printing plate of the present invention has excellent aqueous ink transfer properties and printing durability since a relief layer obtained has excellent elasticity, and printing can be carried out for a long period of time without plastic deformation of the relief layer or degradation of printing durability.

### EXAMPLE

The present invention is explained in further detail below by reference to Examples, but the present invention should not be construed as being limited to these Examples. Furthermore, 'parts' in the description below means 'parts by mass', and '%' means '% by mass', unless otherwise specified.

Moreover, the number-average molecular weight (Mn) of a polymer in the Examples are values measured by a GPC method on the basis of a polystyrene unless otherwise specified.

A diol compound and an isocyanate compound used when producing Component A, and compounds of Component B and Component E used in Examples and Comparative Examples are as follows.

### <Polyol compounds>

Polyester Vylon UR-3210 (Toyobo Co., Ltd., acid value: 0.7 mg KOH/g, hydroxy group value: 2.5 mg KOH/g)
Polyester Elitel UE3220 (Unitika Ltd., acid value: 2 mg KOH/g, hydroxy group value: 3.0 mg KOH/g)
Polyester Vylon UR-1700 (Toyobo Co., Ltd., acid value: 26 mg KOH/g, hydroxy group value: 19.0 mg KOH/g)
Polyester Vylon UR-3500 (Toyobo Co., Ltd., acid value: 35 mg KOH/g, hydroxy group value: 10.0 mg KOH/g)
Polyester Polyester LP022 (The Nippon Synthetic Chemical Industry Co., Ltd., acid value: 0 mg KOH/g, hydroxy group value: 10.0 mg KOH/g)

### <Isocyanate compounds>

Hexamethylene diisocyanate (Tokyo Chemical Industry Co., Ltd.)
Tolylene 2,4-diisocyanate (Tokyo Chemical Industry Co., Ltd.) 4,4'-Diphenylmethane diisocyanate (Tokyo Chemical Industry Co., Ltd.)

### <Component B>

B-1: tricyclodecanedimethanol dimethacrylate (NK Ester DCP) (Shin-Nakamura Chemical Co., Ltd.)
B-2: ditrimethylolpropane tetraacrylate (NK Ester AD-TMP) (Shin-Nakamura Chemical Co., Ltd.)
B-3: dipentaerythritol hexaacrylate (NK Ester A-DPH) (Shin-Nakamura Chemical Co., Ltd.)

### <Component E>

E-1: bis(triethoxysilylpropyl)tetrasulfide (KBE-846, Shin-Etsu Chemical Co., Ltd.)
E-2: tris(3-trimethoxysilylpropyl) isocyanurate (X-12-965, Shin-Etsu Chemical Co., Ltd.)

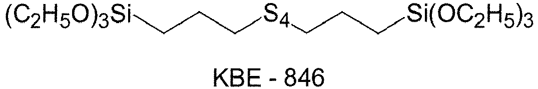

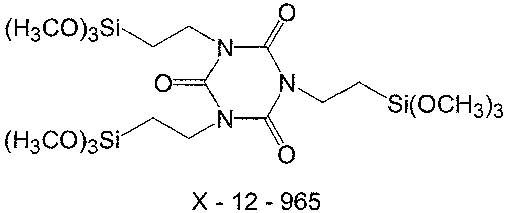

### <Method for preparing polyurethane resins (A-1 to A-9) (Component A)>

In a three-necked round-bottomed flask equipped with a condenser and a stirrer, an amount of polyol compound described in Table 1 corresponding to 0.05 mole as a hydroxy group equivalent was dissolved in 100 mL of *N,N-*dimethylacetamide. 0.102 mole of an isocyanate compound described in Table 1 and 0.1 g of dibutyltin dilaurate were added thereto, and stirring was carried out while heating at 100°C for 8 hours. Subsequently, the mixture was diluted with 100 mL of *N,N-*dimethylformamide and 200 mL of methyl alcohol and stirred for 30 minutes. The reaction solution was poured into 3 L of water while stirring, thus precipitating a white polymer. This polymer was separated by filtration, washed with water, and dried under vacuum, thus giving a polyurethane resin (A-1 to A-9) (Component A). Polyurethane resins A-7 to A-9 are resins that do not correspond to Component A.

The amount of each polyol compound described in Table 1 corresponding to 0.05 mole as a hydroxy group equivalent is as follows.
Vylon UR-3210: 112 g
Elitel UE3220: 93.3 g
Vylon UR-1700: 14.7 g
Vylon UR-3500: 28 g
Polyester LP022: 28 g

When the acid value of the polyurethane resin (A-1 to A-9) was measured, since the weight-average molecular weight of the polyol compound used was large compared with other components used, as shown in Table 1, the acid value was about the same value as that of the polyol compound used.

Furthermore, the acid value of each polyurethane resin was determined by dissolving 1 g of a sample in a mixed solvent of 54 mL of tetrahydrofuran and 6 mL of water and adding a 0.1 mol/L aqueous solution of sodium hydroxide dropwise thereto to thus obtain the neutralization point.

**(Table 1)**

| Polyurethane resin | Polyol compound | Isocyanate compound | Polyol compound weight-average molecular weight | Acid value (mg KOH/g) | Polyurethane resin weight-average molecular weight |
|---|---|---|---|---|---|
| A-1 | Vylon UR-3210 | Hexamethylene isocyanate | 40,000 | 0.7 | 225,000 |
| A-2 | Elitel UE3220 | Hexamethylene isocyanate | 25,000 | 2 | 253,000 |
| A-3 | Vylon UR-1700 | Hexamethylene isocyanate | 16,000 | 26 | 245,000 |
| A-4 | Vylon UR-3500 | Hexamethylene isocyanate | 50,000 | 35 | 274,000 |
| A-5 | Vylon UR-3210 | Tolylene 2,4-diisocyanate | 40,000 | 0.7 | 251,000 |
| A-6 | Vylon UR-3210 | 4,4'-Diphenylmethane diisocyanate | 40,000 | 0.7 | 283,000 |
| A-7 | Polyester LP022 | Hexamethylene isocyanate | 10,000 | 0 | 246,000 |
| A-8 | Polyester LP022 | Tolylene 2,4-diisocyanate | 10,000 | 0 | 238,000 |
| A-9 | Polyester LP022 | 4,4'-Diphenylmethane diisocyanate | 10,000 | 0 | 228,000 |

### (Examples 1 to 56 and Comparative Examples 1 to 20)

### <Method for preparing resin composition for laser engraving>

A three-necked flask equipped with a stirring spatula and a condenser was charged with 60 parts by mass of a polyurethane resin (Component A) described in Table 2 or Table 3 and 150 parts by mass of tetrahydrofuran as a solvent, and the binder was dissolved by heating at 70°C for 120 minutes while stirring. Added to this binder dispersion and stirred were 0.005 parts by mass of Perbutyl Z (*t*-butylperoxybenzoate, NOF Corporation) as a polymerization initiator, 3 parts by mass of 3-mercaptopropylmethyldimethoxysilane (KBM-802, Shin-Etsu Chemical Co., Ltd.) as a chain transfer agent (also corresponding to Component E), 5 parts by mass of Asahi #80 *N*-220 carbon black (Asahi Carbon Co., Ltd.) as a photothermal conversion agent according to Table 2 or Table 3, 0.5 parts by mass of 1,8-diazabicyclo[5.4.0]undeca-7-ene (Wako Pure Chemical Industries, Ltd.) as an alcohol exchange reaction catalyst and, furthermore, 15 parts by mass and 6 parts by mass respectively of an ethylenically unsaturated compound (Component B) and a compound comprising at least one type from a hydrolyzable silyl group and a silanol group (Component E) (silane coupling agent) described in Table 2 or Table 3 below, thus giving a resin composition for laser engraving.

### <Preparation of relief printing plate precursor for laser engraving>

A resin composition for laser engraving was gently cast on a PET substrate so that it did not flow out, heated in an oven at 100°C for 5 hours so as to remove solvent and carry out thermal crosslinking, and then subjected to laser engraving to form a relief layer, thus producing a relief printing plate.

### <Measurement of rinsing properties>

A carbon dioxide laser engraving machine "HELIOS 6010" (Stork Prints) was used for engraving. Engraving conditions were laser output: 500 W, drum rotational speed: 600 cm/sec, and relief depth: 0.50 mm, and a solid printed area of 4 cm square was engraved.

A sample immediately after laser engraving was washed under running tap water at a constant flow rate for 1 minute without any operation such as physical rubbing of the engraved surface, water droplets attached to the surface were wiped using a Kimwipe, and the engraved surface was examined using an SEM (scanning electron microscope; JSM-7401, JEOL) to thus inspect it for the presence or absence of engraving residue on the engraved area. The evaluation criteria were as follows.
A: engraving residue was in powder form, and a clear relief pattern was given.
B: engraving residue was in a high viscidity paste form, and a clear relief pattern was given.
C: engraving residue was in a high viscidity paste form, and a relief pattern could be identified.
D: engraving residue was in a low viscidity paste form, and a relief pattern could be identified.
E: engraving residue was in liquid form, and a relief pattern could be identified.
F: engraving residue was in liquid form, and no clear relief pattern was given.

An evaluation of A, B, C, or D was an acceptable level.

### <Measurement of residue scattering properties>

A carbon dioxide laser engraving machine "HELIOS 6010" (Stork Prints) was used for engraving. PET was placed on the rotational trajectory of an engraving plate attached to the drum, and the amount of droplets (mg/cm²) of liquid engraving residue per unit area scattered by the centrifugal force and attached to the PET was measured. The measured droplet area is shown in Table 2. Engraving conditions were laser output: 500 W, drum rotational speed: 600 cm/sec, and relief depth: 0.30 mm, and a solid printed area of 4 cm square was engraved. The smaller the amount of engraving residue scattered, the better.

Evaluation results are summarized in Table 2 and Table 3. The silane coupling agent (Component E) in the tables shows Components E used other than 3-mercaptopropylmethyldimethoxysilane.

**(Table 2)**

| | (Component A) polyurethane resin | (Component B) ethylenically unsaturated compound | (Component C) polymerization initiator | (Component D) photothermal conversion agent | (Component E) silane coupling agent | Performance evaluation | |
|---|---|---|---|---|---|---|---|
| | | | | | | Rinsing properties | Amount of residue scattered (mg/cm²) |
| Ex. 1 | A-1 | B-1 | Perbutyl Z | None | None | D | 42 |
| Ex. 2 | A-1 | B-1 | Perbutyl Z | Carbon black | None | D | 37 |
| Ex. 3 | A-1 | B-1 | Perbutyl Z | Carbon black | E-1 | D | 34 |
| Ex. 4 | A-1 | B-1 | Perbutyl Z | Carbon black | E-2 | C | 32 |
| Ex. 5 | A-1 | B-2 | Perbutyl Z | None | None | D | 38 |
| Ex. 6 | A-1 | B-2 | Perbutyl Z | Carbon black | None | D | 34 |
| Ex. 7 | A-1 | B-2 | Perbutyl Z | Carbon black | E-1 | C | 30 |
| Ex. 8 | A-1 | B-2 | Perbutyl Z | Carbon black | E-2 | C | 27 |
| Ex. 9 | A-1 | B-3 | Perbutyl Z | None | None | D | 35 |
| Ex. 10 | A-1 | B-3 | Perbutyl Z | Carbon black | None | C | 32 |
| Ex. 11 | A-1 | B-3 | Perbutyl Z | Carbon black | E-1 | C | 27 |
| Ex. 12 | A-1 | B-3 | Perbutyl Z | Carbon black | E-2 | C | 23 |
| Ex. 13 | A-2 | B-1 | Perbutyl Z | None | None | C | 37 |
| Ex. 14 | A-2 | B-1 | Perbutyl Z | Carbon black | None | C | 32 |
| Ex. 15 | A-2 | B-1 | Perbutyl Z | Carbon black | E-1 | C | 29 |
| Ex. 16 | A-2 | B-1 | Perbutyl Z | Carbon black | E-2 | B | 27 |
| Ex. 17 | A-2 | B-2 | Perbutyl Z | None | None | C | 33 |
| Ex. 18 | A-2 | B-2 | Perbutyl Z | Carbon black | None | C | 29 |
| Ex. 19 | A-2 | B-2 | Perbutyl Z | Carbon black | E-1 | B | 25 |
| Ex. 20 | A-2 | B-2 | Perbutyl Z | Carbon black | E-2 | B | 22 |
| Ex. 21 | A-2 | B-3 | Perbutyl Z | None | None | C | 30 |
| Ex. 22 | A-2 | B-3 | Perbutyl Z | Carbon black | None | B | 27 |
| Ex. 23 | A-2 | B-3 | Perbutyl Z | Carbon black | E-1 | B | 22 |
| Ex. 24 | A-2 | B-3 | Perbutyl Z | Carbon black | E-2 | A | 18 |
| Ex. 25 | A-3 | B-1 | Perbutyl Z | None | None | C | 33 |
| Ex. 26 | A-3 | B-1 | Perbutyl Z | Carbon black | None | C | 30 |
| Ex. 27 | A-3 | B-1 | Perbutyl Z | Carbon black | E-1 | B | 26 |
| Ex. 28 | A-3 | B-1 | Perbutyl Z | Carbon black | E-2 | B | 23 |
| Ex. 29 | A-3 | B-2 | Perbutyl Z | None | None | C | 29 |
| Ex. 30 | A-3 | B-2 | Perbutyl Z | Carbon black | None | B | 26 |
| Ex. 31 | A-3 | B-2 | Perbutyl Z | Carbon black | E-1 | B | 21 |
| Ex. 32 | A-3 | B-2 | Perbutyl Z | Carbon black | E-2 | A | 19 |
| Ex. 33 | A-3 | B-3 | Perbutyl Z | None | None | B | 26 |
| Ex. 34 | A-3 | B-3 | Perbutyl Z | Carbon black | None | B | 23 |
| Ex. 35 | A-3 | B-3 | Perbutyl Z | Carbon black | E-1 | A | 18 |
| Ex. 36 | A-3 | B-3 | Perbutyl Z | Carbon black | E-2 | A | 15 |
| Ex. 37 | A-4 | B-1 | Perbutyl Z | None | None | C | 28 |
| Ex. 38 | A-4 | B-1 | Perbutyl Z | Carbon black | None | B | 24 |

**(Table 3)**

| | (Component A) polyurethane resin | (Component B) ethylenically unsaturated compound | (Component C) polymerization initiator | (Component D) photothermal conversion agent | (Component E) silane coupling agent | Performance evaluation | |
|---|---|---|---|---|---|---|---|
| | | | | | | Rinsing properties | Amount of residue scattered (mg/cm²) |
| Ex. 39 | A-4 | B-1 | Perbutyl Z | Carbon black | E-1 | B | 21 |
| Ex. 40 | A-4 | B-1 | Perbutyl Z | Carbon black | E-2 | A | 18 |
| Ex. 41 | A-4 | B-2 | Perbutyl Z | None | None | B | 24 |
| Ex. 42 | A-4 | B-2 | Perbutyl Z | Carbon black | None | B | 21 |
| Ex. 43 | A-4 | B-2 | Perbutyl Z | Carbon black | E-1 | A | 17 |
| Ex. 44 | A-4 | B-2 | Perbutyl Z | Carbon black | E-2 | A | 15 |
| Ex. 45 | A-4 | B-3 | Perbutyl Z | None | None | B | 22 |
| Ex. 46 | A-4 | B-3 | Perbutyl Z | Carbon black | None | A | 18 |
| Ex. 47 | A-4 | B-3 | Perbutyl Z | Carbon black | E-1 | A | 15 |
| Ex. 48 | A-4 | B-3 | Perbutyl Z | Carbon black | E-2 | A | 12 |
| Ex. 49 | A-5 | B-1 | Perbutyl Z | None | None | C | 40 |
| Ex. 50 | A-5 | B-1 | Perbutyl Z | Carbon black | None | C | 36 |
| Ex. 51 | A-5 | B-1 | Perbutyl Z | Carbon black | E-1 | C | 34 |
| Ex. 52 | A-5 | B-1 | Perbutyl Z | Carbon black | E-2 | B | 32 |
| Ex. 53 | A-6 | B-1 | Perbutyl Z | None | None | C | 41 |
| Ex. 54 | A-6 | B-1 | Perbutyl Z | Carbon black | None | C | 37 |
| Ex. 55 | A-6 | B-1 | Perbutyl Z | Carbon black | E-1 | C | 33 |
| Ex. 56 | A-6 | B-1 | Perbutyl Z | Carbon black | E-2 | B | 31 |
| Comp.Ex. 1 | A-7 | B-1 | Perbutyl Z | None | None | F | 65 |
| Comp.Ex. 2 | A-7 | B-1 | Perbutyl Z | Carbon black | None | F | 59 |
| Comp.Ex. 3 | A-7 | B-1 | Perbutyl Z | Carbon black | E-1 | E | 53 |
| Comp.Ex. 4 | A-7 | B-1 | Perbutyl Z | Carbon black | E-2 | D | 51 |
| Comp.Ex. 5 | A-7 | B-2 | Perbutyl Z | None | None | F | 62 |
| Comp.Ex. 6 | A-7 | B-2 | Perbutyl Z | Carbon black | None | E | 56 |
| Comp.Ex. 7 | A-7 | B-2 | Perbutyl Z | Carbon black | E-1 | E | 51 |
| Comp.Ex. 8 | A-7 | B-2 | Perbutyl Z | Carbon black | E-2 | D | 49 |
| Comp.Ex. 9 | A-7 | B-3 | Perbutyl Z | None | None | E | 59 |
| Comp.Ex. 10 | A-7 | B-3 | Perbutyl Z | Carbon black | None | E | 54 |
| Comp.Ex. 11 | A-7 | B-3 | Perbutyl Z | Carbon black | E-1 | D | 47 |
| Comp.Ex. 12 | A-7 | B-3 | Perbutyl Z | Carbon black | E-2 | D | 45 |
| Comp.Ex. 13 | A-8 | B-1 | Perbutyl Z | None | None | F | 65 |
| Comp.Ex. 14 | A-8 | B-1 | Perbutyl Z | Carbon black | None | F | 60 |
| Comp.Ex. 15 | A-8 | B-1 | Perbutyl Z | Carbon black | E-1 | E | 53 |
| Comp.Ex. 16 | A-8 | B-1 | Perbutyl Z | Carbon black | E-2 | D | 50 |
| Comp.Ex. 17 | A-9 | B-1 | Perbutyl Z | None | None | F | 67 |
| Comp.Ex. 18 | A-9 | B-1 | Perbutyl Z | Carbon black | None | F | 60 |
| Comp.Ex. 19 | A-9 | B-1 | Perbutyl Z | Carbon black | E-1 | E | 54 |
| Comp.Ex. 20 | A-9 | B-1 | Perbutyl Z | Carbon black | E-2 | D | 51 |

## Claims

1. A resin composition for laser engraving, comprising
(Component A) a polyurethane resin comprising a carboxy group-containing polymeric polyol compound-derived constituent unit and an isocyanate compound-derived constituent unit,
(Component B) an ethylenically unsaturated compound, and
(Component C) a polymerization initiator.

2. The resin composition for laser engraving according to Claim 1, wherein Component A has an acid value of 1 to 200 mg KOH/g.

3. The resin composition for laser engraving according to Claim 1 or 2, wherein Component C is a thermopolymerization initiator.

4. The resin composition for laser engraving according to any one of Claims 1 to 3, wherein the composition further comprises (Component D) a photothermal conversion agent.

5. The resin composition for laser engraving according to Claim 4, wherein Component D is carbon black.

6. The resin composition for laser engraving according to any one of Claims 1 to 5, wherein the composition further comprises (Component E) a compound comprising at least one type from a hydrolyzable silyl group and a silanol group.

7. The resin composition for laser engraving according to Claim 6, wherein Component E is a compound comprising at least an alkoxy group on a silicon atom.

8. The resin composition for laser engraving according to any one of Claims 1 to 7, wherein the carboxy group-containing polymeric polyol compound is a polyester resin comprising at least one carboxy group and at least two hydroxy groups.

9. The resin composition for laser engraving according to any one of Claims 1 to 8, wherein the isocyanate compound is an alkylene diisocyanate having 2 to 10 carbons.

10. A flexographic printing plate precursor for laser engraving comprising above a support a relief-forming layer comprising the resin composition for laser engraving according to any one of Claims 1 to 9.

11. A flexographic printing plate precursor for laser engraving comprising above a support a crosslinked relief-forming layer formed by crosslinking by means of light and/or heat a relief-forming layer comprising the resin composition for laser engraving according to any one of Claims 1 to 9.

12. A process for producing a flexographic printing plate precursor for laser engraving, comprising
a layer formation step of forming a relief-forming layer comprising the resin composition for laser engraving according to any one of Claims 1 to 9, and
a crosslinking step of crosslinking the relief-forming layer by means of light and/or heat to thus obtain a flexographic printing plate precursor comprising the crosslinked relief-forming layer.

13. A process for making a flexographic printing plate, comprising an engraving step of laser-engraving the flexographic printing plate precursor for laser engraving according to Claim 11 to thus form a relief layer.

14. A flexographic printing plate made by the process according to Claim 13.
